# EUROPEAN PATENT APPLICATION

(11) **EP 4 549 850 A1**
(43) Date of publication of application: **07.05.2025**
(21) Application number: 24208733.6
(22) Date of filing: 24.10.2024
(51) Int. Cl.: F25D 11/02, F25B 40/00, F25B 41/20, F25D 17/02, H05K 7/20, F25B 25/00, F25B 9/00

(54) **COOLING DISTRIBUTION UNIT AND METHOD FOR OPERATING THE SAME**

(30) Priority: 02.11.2023 IT 202300023094
(71) Applicant: Schneider Electric IT Corporation, Foxboro, MA 02035 (US)
(72) Inventor: CASSON, Vanna, Andover, 01810 (US); FRIZZIERO, Maurizio, Andover, 01810 (US)
(74) Representative: Plasseraud IP

(57) **Abstract**

A cooling distribution unit includes a refrigeration unit configured to be coupled to a dry cooling unit. The refrigeration unit is configured to receive a first cooling fluid in relatively cool condition from the dry cooling unit and to output the first cooling fluid in relatively warm condition to the dry cooling unit for cooling. The cooling distribution unit further includes a first control valve coupled to the refrigeration unit. The first control valve is configured to output a first portion of a second cooling fluid at a first temperature. The cooling distribution unit further includes a second control valve coupled to the refrigeration unit. The second control valve is configured to output a second portion of the second cooling fluid at a second temperature.

## Description

### BACKGROUND

### Technical Field

The technical field relates generally to cooling systems, and more particularly, to cooling systems that combine different techniques for heat removal from rack powered equipment within data centers.

### Background Discussion

A data center may include a building, a dedicated space within a building, such as a room or closet, or a group of buildings used to house electronic equipment, such as servers, and associated components, such as telecommunications equipment, networking equipment, and storage systems. Data centers often include redundant or backup components and infrastructure for power supply, data communication connections, environmental controls, e.g., air condition and fire suppression, and various security devices. Data centers can vary widely in terms of size, power requirements, redundancy, and overall structure. Managing heat generated from the electronic equipment within the data center ensures proper operation of the electronic equipment and ensures proper operation and enhances life expectancy of the electronic equipment.

### SUMMARY

The disclosure is defined in the appended independent claims. Dependent claims constitute embodiments of the disclosure. In the present description and drawings, any examples and technical descriptions of apparatuses products and/or methods which are not covered by the claims should be taken as background art or examples useful for understanding the disclosure.

### BRIEF DESCRIPTION OF DRAWINGS

Various aspects of at least one embodiment are discussed below with reference to the accompanying figures, which are not intended to be drawn to scale. The figures are included to provide an illustration and a further understanding of the various aspects and embodiments, and are incorporated in and constitute a part of this specification, but are not intended as a definition of the limits of any particular embodiment. The drawings, together with the remainder of the specification, serve to explain principles and operations of the described and claimed aspects and embodiments. In the figures, each identical or nearly identical component that is illustrated in various figures is represented by a like numeral. For purposes of clarity, not every component may be labeled in every figure. In the figures:
FIG. 1 is a perspective view of a cooling distribution unit of an embodiment of the present disclosure;
FIG. 2 is a schematic view of liquid cooled equipment racks that are cooled by a chiller and/or dry cooling unit and the cooling distribution unit;
FIG. 3 is a schematic view of sets of liquid cooling racks requiring different cooling temperatures that are cooled by a chiller and/or dry cooling unit and the cooling distribution unit;
FIG. 4 is a diagram of a cooling distribution unit of an embodiment of the present disclosure;
FIG. 5 is a diagram of a cooling distribution unit of another embodiment of the present disclosure;
FIG. 6 is a diagram of a cooling distribution unit of yet another embodiment of the present disclosure;
FIG. 7 is a diagram showing an exemplary cooling distribution unit in an economization mode of operation;
FIG. 8 is a diagram showing an exemplary cooling distribution unit in a mixed (hybrid) mode of operation; and
FIG. 9 is a diagram showing an exemplary cooling distribution unit in a mechanical mode of operation.

### DETAILED DESCRIPTION

Cooling systems for removing heat in conditioned spaces, such as IT environments, use heat transport fluids, such as air, water, or refrigerant to transport heat energy from indoors to outdoors. Many cooling systems rely on the refrigeration cycle as the primary means of cooling. Pumped refrigerant systems provide isolation between the primary heat removal system and IT equipment. The direct air and indirect air methods rely on the outdoor conditions as the primary means of cooling, which makes them more efficient for mild climates.

Although the examples discussed herein refer to an IT environment, the methods and system discussed in this disclosure may be applied to any confined space (also referred to herein as a "conditioned space"), such as a room, inside a building or other structure that contains air to be cooled. For example, the space to be cooled may be one or more rooms in a public or private building, such as a private residence, office space, or other commercial or municipal space, or may include spaces within an industrial or manufacturing complex. Furthermore, more than one cooling device may be used for cooling.

In some embodiments, the space being cooled is a data center or IT environment. A data center may include one or more rooms or spaces that contain rows of equipment racks designed to house electronic equipment, such as data processing, networking, and telecommunications equipment. During operation, the electronic equipment generates heat that needs to be removed to ensure the continued performance, reliability, and useful life of the equipment components housed by the equipment racks. One or more embodiments of the systems disclosed herein are designed to remove heat produced by the electronic equipment within the data center and return cool air back to the data center.

One example of a method for heat removal in an IT environment includes an in-row device that is paired with a dry cooling unit. A dry cooling unit, also referred to herein as a "dry heat rejection unit," or "outdoor heat exchanger" is a type of heat exchanger where air is used to cool the transport fluid (i.e., glycol) flowing through the cooling coils. Another example of a method for heat removal is use of a chiller or "wet" cooler.

In this type of system, the refrigeration cycle components (e.g., the dry cooling unit) may be positioned in an enclosure external to the space being cooled and a heat exchanger may be positioned in the space being cooled. The heat exchanger uses flowing glycol to collect heat from the refrigerant of a refrigeration unit and transports it away from the IT environment. The glycol flows via pipes to the dry cooling unit where the heat is rejected to the outside atmosphere. A pump and other components, such as a motor, are used to circulate the glycol in its loop to and from the refrigeration unit and dry cooling unit. However, embodiments of the present disclosure place a cooling distribution unit in the space being cooled.

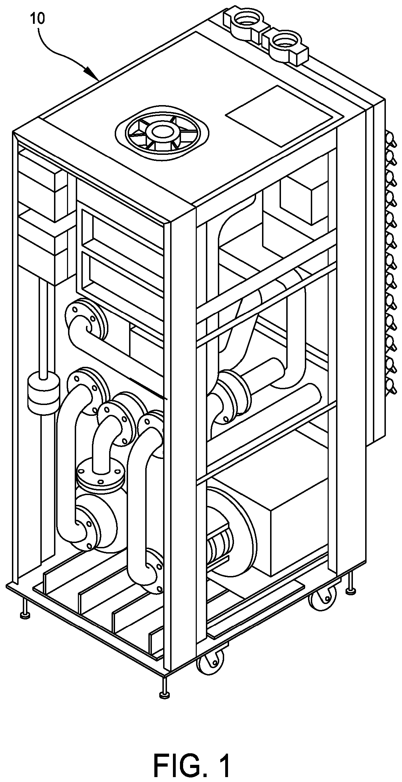

Referring to FIG. 1, one method of cooling electronic equipment employs a liquid cooling architecture including a cooling distribution unit, sometimes referred to as a CDU, which generally indicated at 10. With the advent of technology linked to liquid cooling, the cooling distribution unit 10 is configured to distribute cooling fluid between the refrigeration units, e.g., chillers or dry cooling units, and the various servers. In one embodiment, the cooling distribution unit 10 includes a water or a water/glycol unit, having plate exchangers and a series of pumps, with fixed or variable speed, which serve to distribute fluid. The fluid distribution used within the cooling distribution unit 10 can be done with different technologies and approaches.

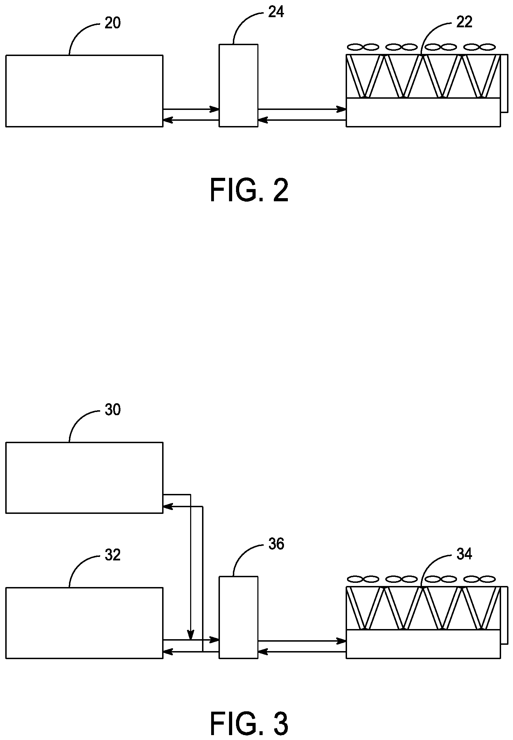

Referring to FIG. 2, a row of liquid cooled IT racks, indicated at 20, are cooled by cooling fluid provided by a chiller and/or dry cooler, indicated at 22, via a cooling distribution unit 24. As shown, the units 22 that produce cooled fluid are mainly chillers with built-in free cooling/economizing systems, or dry cooling units. These units 22, which may be large in terms of cooling capacity, are normally placed outdoor and on the roof of the data center. Liquid cooling applications require working temperatures higher than those traditionally required for air-cooled IT applications, and this leads to an increase in economizer applications by dry cooling units, cooling towers, and so on. Even in applications with integrated free cooling chillers, or water-cooled chillers coupled with dry cooling units, the number of hours per year in which the contribution of the compressor (mechanical operation) is decreases and will decrease in the future compared to the past.

Referring to FIG. 3, a first row of IT racks, indicated at 30, and a second row of IT racks, indicated at 32, are cooled by cooling fluid provided by a chiller and/or dry cooler, indicated at 34, via a cooling distribution unit 36. In the shown embodiment, the first row of IT racks includes air-cooled IT racks requiring a lower temperature of cooling and the second row of IT racks includes liquid-cooled IT racks requiring a higher temperature of cooling. The cooling distribution unit 36 is configured to deliver, sometimes referred to as output, cooling fluid to the first row of liquid cooled IT racks 30 at a first temperature and to deliver cooling fluid to the second row of liquid cooled IT racks 32 at a second temperature, which as mentioned above may be higher than the first temperature. It is expected that in liquid cooling applications, it is not possible to remove all the heat generated by the servers. For this reason, a certain percentage has to be removed by traditional air-cooled systems. There may also be data center applications in which not all servers are liquid cooled, but some of them may require air cooling. In both these cases, it is up to the system to distribute the heat at least to two different temperature levels.

With the cooling distribution units described herein, reference to a positive pressure means that the water pressure at the servers of the liquid cooled IT racks is higher than atmospheric pressure. In this case, the architecture is normally operated by a circulating pump. Reference to a negative pressure means that the water pressure at the servers of the liquid cooled IT racks is lower than atmospheric pressure. In this case, the architecture is operated by a circulating pump installed after the servers or by an ejector, or in general by a device able to keep the pressure below the atmospheric one, as will be described in greater detail below.

Embodiments of the present disclosure are configured to be employed within any type of data center including new data centers, existing data center, and hybrid data center. With new data centers, the ability to install a motorized CDU indoors enables the exploitation of the entire external space available for economization systems (adiabatic or not), and therefore to have the maximum possible surface available, without having to dedicate space for cooling units with compressors. With existing data centers, there may be a consistent limit of the impact on the hydraulic architecture, if compared to water-cooled chillers and dry cooling units. The hydraulic infrastructure that is already existing can be simplified. Moreover, a modular approach is allowed in that the customer is not forced to change completely this infrastructure. With hybrid data centers, it is possible to take advantage of the double set point, without being obliged, with only one set point, to choose the lower one, decreasing the efficiency of the whole system.

Embodiments of the present disclosure are directed to the provision of an indoor cooling unit containing both all the typical devices of cooling distribution units, but at the same time integrating a complete refrigeration circuit, which can run when the external economizers are no longer sufficient, therefore in very high ambient temperature conditions. Moreover, this concept allows to have units with set points different each other, located within the individual data center, without being forced to have only one outdoor big chiller on the roof with a water set point equal to the minimum between the temperatures required and therefore working at its worst efficiency.

A motorized cooling distribution unit may be connected on one side to the liquid cooling system (working with negative or positive pressure), and on the other to the economization system positioned outside.

Embodiments of the present disclosure further contemplate different modes of operation, including an economization mode, a mixed (hybrid) mode, and a mechanical mode. For each working mode is indicated which valves are open or closed and if the compressor is running or not.

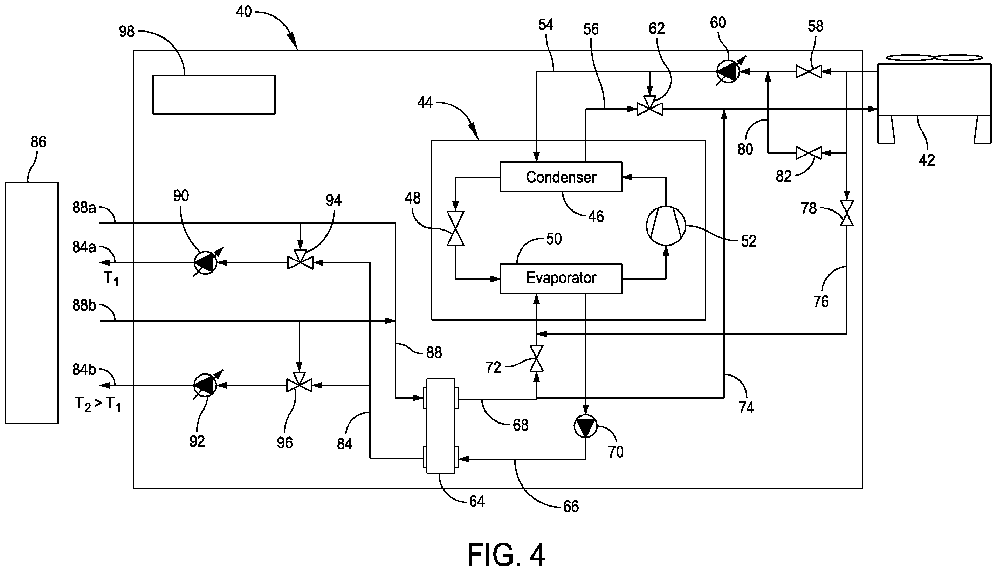

Referring to FIG. 4, a cooling distribution unit is generally indicated at 40. As shown, the cooling distribution unit is connected to a dry cooling unit 42, which as described above may be located outside the data center facility. The cooling distribution unit 40 may be located within the data center facility. The dry cooling unit 42 is configured to receive relatively warm cooling fluid from the cooling distribution unit 40 and to deliver relatively cool cooling fluid to the cooling distribution unit. Any suitable medium can be used as the cooling fluid, including water, a water/glycol mix, or a liquid refrigerant.

The cooling distribution unit 40 includes a refrigeration unit, generally indicated at 44, having a condenser 46, a thermal expansion valve 48, sometimes referred to herein simply as a valve, an evaporator 50, and a compressor 52, which together operate to generate a vapor-compression cycle. As is known, a vapor-compression system employs a circulating liquid refrigerant as a cooling medium to absorb and remove heat from a space or medium to be cooled. Circulating refrigerant enters the compressor 52 in a thermodynamic state known as a saturated vapor and is compressed to a higher pressure, resulting in a higher temperature as well. The hot, compressed vapor is then in the thermodynamic state known as a superheated vapor and it is at a temperature and pressure at which it can be condensed with either cooling water or cooling air flowing across the coil or tubes.

The superheated vapor then passes through the condenser 46, where heat is transferred from the circulating refrigerant to an external medium, allowing the gaseous refrigerant to cool and condense into a liquid. The rejected heat is carried away by either the water or the air, depending on the type of condenser. The condensed liquid refrigerant, in the thermodynamic state known as a saturated liquid, is next routed through the thermal expansion valve 48 in which the saturated liquid undergoes an abrupt reduction in pressure, which lowers the temperature of the liquid and vapor refrigerant mixture to where it is colder than the temperature of the enclosed space to be refrigerated. The cold refrigerant liquid and vapor mixture is then routed through the coil or tubes in the evaporator 50. Air in the enclosed space circulates across the coil or tubes due to either thermal convection or a fan. Since the air is warmer than the cold liquid refrigerant, heat is transferred which cools the air and causes evaporation of the liquid, returning it to a gaseous state while absorbing heat. To complete the refrigeration cycle, the refrigerant vapor from the evaporator 50 is again a saturated vapor and is routed back into the compressor 52.

As shown in FIG. 4, a supply line 54 is provided to deliver a cooling fluid, sometimes referred to herein as a first cooling fluid, in a relatively cooled state from the dry cooling unit 42 to the condenser 46 of the refrigeration unit 44 and a return line 56 is provided to return the cooling fluid in a relatively warmed or heated state from the condenser of the refrigeration unit to the dry cooling unit. As shown, the supply line 54 includes a valve 58, a pump 60 and a three-way valve 62 to control delivery of relatively cool cooling fluid. The three-way valve 62 can be controlled to divert some or all of the cooling fluid from the supply line 54 to the return line 56.

The cooling distribution unit 40 further includes a heat exchanger 64 in fluid communication with the evaporator 50 of the refrigeration unit 44. Specifically, a supply line 66 is provided to deliver a cooling fluid, sometimes referred to herein as a third cooling fluid, in a relatively cooled state from the evaporator 50 of the refrigeration unit 44 to the heat exchanger 64 and a return line 68 is provided to return the cooling fluid in a relatively warmed or heated state from the heat exchanger to the evaporator of the refrigeration unit. In one embodiment, the cooling fluid is a water/glycol mix and the heat exchanger 64 is a brazed plate heat exchanger. As shown, a pump 70 is provided in the supply line 66 to move cooling fluid from the evaporator 50 of the refrigeration unit 44 to the heat exchanger 64. A valve 72 is provided in the return line 68 to control an amount of cooling fluid from the heat exchanger 64 to the evaporator 50 of the refrigeration unit 44. The return line 68 is further in fluid communication with the return line 56 connecting the condenser 46 of the refrigeration unit 44 to the dry cooling unit by line 74. Another line 76 is provided from the supply line 54 to the return line 68 after valve 72. Line 76 includes a valve 78 may be provided between the supply line 54 connecting the dry cooling unit 42 to the condenser 46 of the refrigeration unit 44 and the return line 68 connecting the heat exchanger 64 to the evaporator 50 of the refrigeration unit 44. Another line 80 is provided between line 76 to supply line 54, with a valve 82 being provided to control flow of cooling fluid through line 80.

As noted above, the supply line 66 includes the pump 70 to move cooling fluid from the evaporator 50 of the refrigeration unit 44 to the heat exchanger 64. The return line 68 includes the valve 72 to control the flow of cooling fluid being delivered by the heat exchanger 64 to the evaporator 50 of the refrigeration unit 44. Further control is provided by valves 78 and 82 associated with line 77 in fluid communication with return line 68.

The heat exchanger 64 further is configured to include a supply line 84 to deliver a cooling fluid, sometimes referred to herein as a second cooling fluid, in a relatively cooled state to a liquid cooled equipment rack 86 and a return line 88 to return the cooling fluid in a relatively warmed or heated state to the heat exchanger 64. As shown, the supply line 84 includes a first supply line portion 84a to deliver a first portion of cooling fluid to electronic equipment located in the liquid cooled equipment rack 86 and a second supply line portion 84b to deliver a second portion of cooling fluid to another electronic equipment located in the liquid cooled equipment rack 86 or in another liquid cooled equipment rack. Similarly, the return line 88 includes a first return line portion 88a to deliver the first portion of cooling fluid to the heat exchanger 64 and a second return line portion 88b to deliver the second portion of cooling fluid to the heat exchanger 64.

In the shown embodiment, the first supply line portion 84a includes a variable speed pump 90 to move the first portion of cooling fluid to the liquid cooled equipment rack 86. The second supply line portion 84b includes a variable speed pump 92 to move the second portion of the cooling fluid to the liquid cooled equipment rack 86. A three-way valve 94 is provided and in fluid communication with the first supply line portion 84a and the first return line 88a to control the amount of the first portion of cooling fluid to and from the liquid cooled equipment rack 86. Similarly, a three-way valve 96 is provided and in fluid communication with the second supply line portion 84b and the second return line portion 88b to control the amount of the second portion of cooling fluid to and from the liquid cooled equipment rack 86.

It should be noted that the three-way valve 94 may be referred to herein as a first control valve and that the three-way valve 96 may be referred to herein as a second control valve. Although FIG. 4 shows the heat exchanger 64 being disposed between the refrigeration unit 44 and the first control valve, e.g., three-way valve 94, and the second control valve, e.g., three-way valve 96, it should be noted that FIG. 4 shows a schematic representation of the location of the heat exchanger, which may or may not correspond to a physical location. One side of the heat exchanger 64 is coupled to the evaporator 50 of the refrigeration unit 44 and an opposite side of the heat exchanger 64 is coupled to the three-way valves 94, 96.

One aspect of the present disclosure is that by controlling the pumps 90, 92 and the three-way valves 94, 96, a temperature of cooling fluid delivered by the first supply line portion 84a and a temperature of cooling fluid delivered by the second supply line portion 84b can be controlled. As mentioned above, sometimes it is desirable to provide cooling fluid to liquid cooled equipment at different or varying temperatures. In one example, the variable speed pump 90 and the three-way valve 94 can be configured to deliver a first portion of cooling fluid through the first supply line portion 84a at a first temperature, e.g., T₁. The variable speed pump 92 and the three-way valve 96 can be configured to deliver a second portion of cooling fluid through the second supply line portion 84b at a second temperature, e.g., T₂, in which the second temperature is greater than the first temperature. Suitable temperature sensors can be provided to detect temperatures of the first portion of the cooling fluid in the first supply line portion 84a and the second portion of the cooling fluid in the second supply line portion 84b.

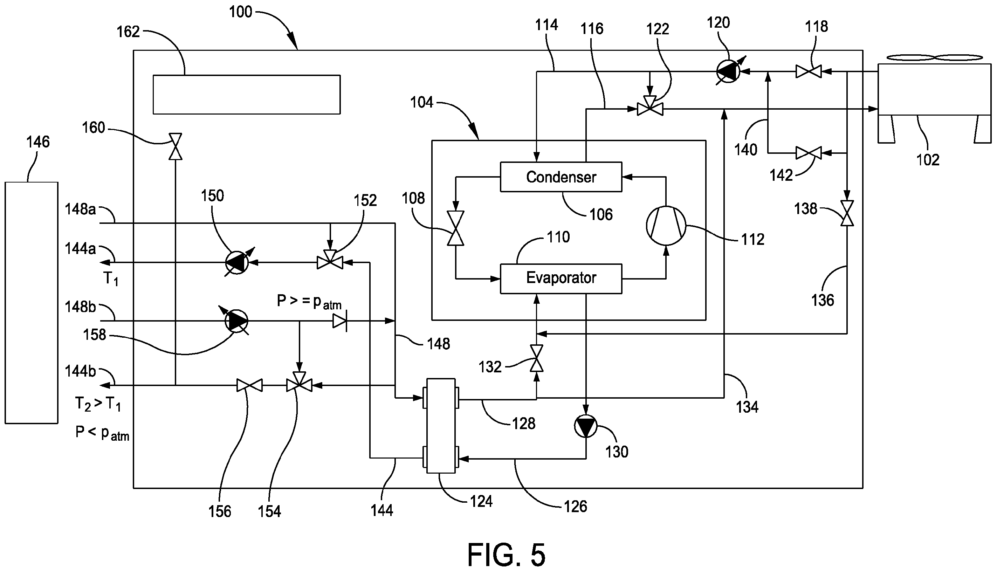

Referring to FIG. 5, in another embodiment, a cooling distribution unit is generally indicated at 100. With this embodiment, as will be described in greater detail below, in addition to controlling a temperature of cooling fluid, a pressure of cooling fluid delivered to the liquid cooled equipment rack or racks can be controlled. As shown, the cooling distribution unit 100 is connected to a dry cooling unit 102, which as described above may be located outside the data center facility. As with cooling distribution unit 40, the cooling distribution unit 100 may be located within the data center facility. The dry cooling unit 102 is configured to receive relatively warm cooling fluid from the cooling distribution unit 100 and to deliver relatively cool cooling fluid to the cooling distribution unit.

The cooling distribution unit 100 includes a refrigeration unit, generally indicated at 104, having a condenser 106, a thermal expansion valve 108, an evaporator 110, and a compressor 112, which together operate to generate a vapor-compression cycle. A supply line 114 is provided to deliver a cooling fluid, sometimes referred to herein as a first cooling fluid, in a relatively cooled state from the dry cooling unit 102 to the condenser 106 of the refrigeration unit 104 and a return line 116 is provided to return the cooling fluid in a relatively warmed or heated state from the condenser 106 of the refrigeration unit 104 to the dry cooling unit 102. As shown, the supply line 114 includes a valve 118, a pump 120, and a three-way valve 122 to control delivery of relatively cool cooling fluid to the condenser 106 of the refrigeration unit 104. The three-way valve 122 can be controlled to deliver some or all of the cooling fluid to the return line 116.

The cooling distribution unit 100 further includes a heat exchanger 124 in fluid communication with the evaporator 110 of the refrigeration unit 104. Specifically, a supply line 106 is provided to deliver a cooling fluid, sometimes referred to herein as a third cooling fluid, in a relatively cooled state from the evaporator 110 of the refrigeration unit 104 to the heat exchanger 124 and a return line 128 is provided to return the cooling fluid in a relatively warmed or heated state from the heat exchanger 124 to the evaporator 110 of the refrigeration unit 104. In one embodiment, the cooling fluid is a water/glycol mix and the heat exchanger 124 is a brazed plate heat exchanger. As shown, a pump 130 is provided in the supply line 126 to move cooling fluid from the evaporator 110 of the refrigeration unit 104 to the heat exchanger 124. A valve 132 is provided in the return line 128 to control an amount of cooling fluid from the heat exchanger 124 to the evaporator 110 of the refrigeration unit 104. The return line 128 is further in fluid communication with the return line 116 connecting the condenser 106 of the refrigeration unit 104 to the dry cooling unit by line 134. Another line 136 is provided from the supply line 114 to the return line 128 after valve 132. Line 136 includes a valve 138 may be provided between the supply line 114 connecting the dry cooling unit 102 to the condenser 106 of the refrigeration unit 104 and the return line 128 connecting the heat exchanger 124 to the evaporator 110 of the refrigeration unit 104. Another line 140 is provided between line 136 to supply line 114, with a valve 142 being provided to control flow of cooling fluid through line 140.

As noted above, the supply line 126 includes the pump 130 to move cooling fluid from the evaporator 110 of the refrigeration unit 104 to the heat exchanger 124. The return line 128 includes the valve 132 to control the flow of cooling fluid being delivered by the heat exchanger 124 to the evaporator 110 of the refrigeration unit 104. Further control is provided by valves 138 and 142 associated with line 136 in fluid communication with return line 128.

The heat exchanger 124 further is configured to include a supply line 144 to deliver a cooling fluid, sometimes referred to herein as a second cooling fluid, in a relatively cooled state to a liquid cooled equipment rack 146 and a return line 148 to return the cooling fluid in a relatively warmed or heated state to the heat exchanger 124. As shown, the supply line 144 includes a first supply line portion 144a to deliver a first portion of cooling fluid to electronic equipment located in the liquid cooled equipment rack 146 and a second supply line portion 144b to deliver a second portion of cooling fluid to another electronic equipment located in the liquid cooled equipment rack 146 or in another liquid cooled equipment rack. Similarly, the return line 148 includes a first return line portion 148a to deliver the first portion of cooling fluid to the heat exchanger 124 and a second return line portion 148b to deliver the second portion of cooling fluid to the heat exchanger 124. In the shown embodiment, the first supply line portion 144a includes a variable speed pump 150 to move the first portion of cooling fluid to the liquid cooled equipment rack 146. A three-way valve 152 is provided and in fluid communication with the first supply line portion 144a and the first return line 148a to control the amount of the first portion of cooling fluid to and from the liquid cooled equipment rack 146. Another three-way valve 154 is provided and in fluid communication with the second supply line portion 144b and the second return line 148b to control the amount of the second portion of cooling fluid to and from the liquid cooled equipment rack 146.

The second supply line portion 144b includes a throttling valve 156 to control the flow of the second portion of cooling fluid to the liquid cooled equipment rack 146. Further, the second return line 148b includes a variable speed pump 158 to move the second portion of cooling fluid from the liquid cooled equipment rack 146 to the heat exchanger 124. The purpose of the throttling valve 156 and the variable speed pump 158 will be described in greater detail below. A bleed valve 160 is provided to release air from the second supply line portion 144b.

It should be noted that the three-way valve 152 may be referred to herein as a first control valve and that the three-way valve 154 may be referred to herein as a second control valve. Although FIG. 5 shows the heat exchanger 124 being disposed between the refrigeration unit 104 and the first control valve, e.g., three-way valve 152, and the second control valve, e.g., three-way valve 154, it should be noted that FIG. 5 shows a schematic representation of the location of the heat exchanger, which may or may not correspond to a physical location. One side of the heat exchanger 124 is coupled to the evaporator 110 of the refrigeration unit 104 and an opposite side of the heat exchanger 124 is coupled to the three-way valves 152, 154.

One aspect of the present disclosure is that by controlling the pump 150 and the three-way valves 152, 154, a temperature of cooling fluid delivered by the first supply line portion 144a and a temperature of cooling fluid delivered by the second supply line portion 144b can be controlled. As previously described, sometimes it is desirable to provide cooling fluid to liquid cooled equipment at different or varying temperatures. In one example, the variable speed pump 150 and the three-way valve 152 can be configured to deliver a first portion of cooling fluid through the first supply line portion 144a at a first temperature, e.g., T₁. The throttling valve 156, the variable speed pump 158, and the three-way valve 154 can be configured to deliver a second portion of cooling fluid through the second supply line portion 144b at a second temperature, e.g., T₂, in which the second temperature is greater than the first temperature. Suitable temperature sensors can be provided to detect temperatures of the first portion of the cooling fluid in the first supply line portion 144a and the second portion of the cooling fluid in the second supply line portion 144b.

Another aspect of the present disclosure is that by controlling the throttling valve 156 and the pump 158, a pressure of the second portion of cooling fluid can be controlled. It may be desirable to deliver cooling fluid below atmospheric pressure. For example, in configurations where leakage is to be avoided, delivering fluid under atmospheric pressure will help to prevent any such leakage. The pressure of the second portion of the cooling fluid through the second supply line portion 144b can be lowered by manipulating the throttling valve 156 and the pump 158. In one example, the pump 150 and the three-way valve 152 can be configured to deliver a first portion of cooling fluid through the first supply line portion 144a at a first pressure, e.g., P₁. The throttling valve 156, the pump 158, and the three-way valve 154 can be configured to deliver a second portion of cooling fluid through the second supply line portion 144b at a second pressure, e.g., P₂, in which the second pressure is greater than the first pressure.

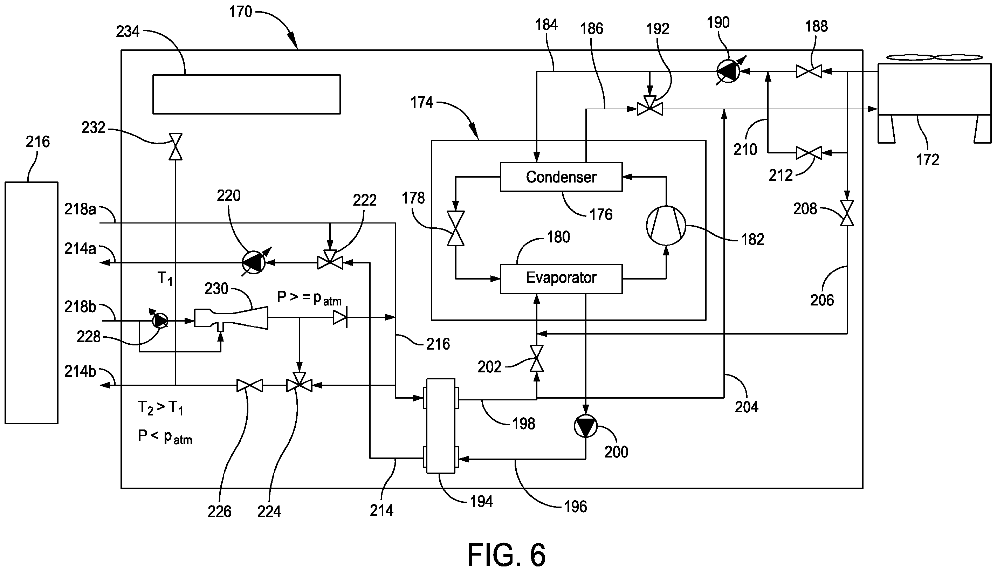

Referring to FIG. 6, in another embodiment, a cooling distribution unit is generally indicated at 170. With this embodiment, as will be described in greater detail below, in addition to controlling a temperature of cooling fluid, a pressure of cooling fluid delivered to the liquid cooled equipment rack or racks can be controlled that is an alternative to the cooling distribution unit 100. As shown, the cooling distribution unit 170 is connected to a dry cooling unit 172, which as described above may be located outside the data center facility. As with cooling distribution units 40, 100, the cooling distribution unit 170 may be located within the data center facility. The dry cooling unit 172 is configured to receive relatively warm cooling fluid from the cooling distribution unit 170 and to deliver relatively cool cooling fluid to the cooling distribution unit.

The cooling distribution unit 170 includes a refrigeration unit, generally indicated at 174, having a condenser 176, a thermal expansion valve 178, an evaporator 180, and a compressor 182, which together operate to generate a vapor-compression cycle. A supply line 184 is provided to deliver a cooling fluid, sometimes referred to herein as a first cooling fluid, in a relatively cooled state from the dry cooling unit 172 to the condenser 176 of the refrigeration unit 174 and a return line 186 is provided to return the cooling fluid in a relatively warmed or heated state from the condenser 176 of the refrigeration unit 174 to the dry cooling unit 172. As shown, the supply line 184 includes a valve 188, a pump 190, and a three-way valve 192 to control delivery of relatively cool cooling fluid. The three-way valve 192 can be controlled to deliver some or all of the cooling fluid to the return line 186.

The cooling distribution unit 170 further includes a heat exchanger 194 in fluid communication with the condenser 176 of the refrigeration unit 174. Specifically, a supply line 196 is provided to deliver a cooling fluid, sometimes referred to herein as a third cooling fluid, in a relatively cooled state from the evaporator 180 of the refrigeration unit 174 to the heat exchanger 194 and a return line 198 is provided to return the cooling fluid in a relatively warmed or heated state from the heat exchanger to the evaporator 180 of the refrigeration unit 174. In one embodiment, the cooling fluid is a water/glycol mix and the heat exchanger is a brazed plate heat exchanger. As shown, a pump 200 is provided in the supply line 196 to move cooling fluid from the evaporator 180 of the refrigeration unit 174 to the heat exchanger 194. A valve 202 is provided in the return line 198 to control an amount of cooling fluid from the heat exchanger 194 to the evaporator 180 of the refrigeration unit 174. The return line 198 is further in fluid communication with the return line 186 connecting the condenser 176 of the refrigeration unit 174 to the dry cooling unit by line 204. Another line 206 is provided from the supply line 184 to the return line 198 after valve 202. Line 206 includes a valve 208 may be provided between the supply line 184 connecting the dry cooling unit 172 to the condenser 176 of the refrigeration unit 174 and the return line 198 connecting the heat exchanger 194 to the evaporator 180 of the refrigeration unit 174. Another line 210 is provided between line 206 to supply line 184, with a valve 212 being provided to control flow of cooling fluid through line 210.

The heat exchanger 194 further is configured to include a supply line 214 to deliver a cooling fluid, sometimes referred to herein as a second cooling fluid, in a relatively cooled state to a liquid cooled equipment rack 216 and a return line 218 to return the cooling fluid in a relatively warmed or heated state to the heat exchanger 194. As noted above, the supply line 196 includes the pump 200 to move cooling fluid from the evaporator 180 of the refrigeration unit 174 to the heat exchanger 194. The return line 198 includes the valve 202 to control the flow of cooling fluid being delivered by the heat exchanger 194 to the evaporator 180 of the refrigeration unit 174. Further control is provided by valves 208 and 212 associated with line 206 in fluid communication with return line 198.

As shown, the supply line 214 includes a first supply line portion 214a to deliver a first portion of cooling fluid to electronic equipment located in the liquid cooled equipment rack 216 and a second supply line portion 214b to deliver a second portion of cooling fluid to another electronic equipment located in the liquid cooled equipment rack 216 or in another liquid cooled equipment rack. Similarly, the return line 218 includes a first return line portion 218a to deliver the first portion of cooling fluid to the heat exchanger 194 and a second return line portion 218b to deliver the second portion of cooling fluid to the heat exchanger 194. In the shown embodiment, the first supply line portion 214a includes a variable speed pump 220 to move the first portion of cooling fluid to the liquid cooled equipment rack 216. A three-way valve 222 is provided and in fluid communication with the first supply line portion 214a and the first return line portion 218a to control the amount of the first portion of cooling fluid to and from the liquid cooled equipment rack 216. Another three-way valve 224 is provided and in fluid communication with the second supply line portion 214b and the second return line portion 218b to control the amount of the second portion of cooling fluid to and from the liquid cooled equipment rack 216.

The second supply line portion 214b includes a throttling valve 226 to control the flow of the second portion of cooling fluid to the liquid cooled equipment rack 216. Further, the second return line portion 218b includes a variable speed pump 228 to move the second portion of cooling fluid from the liquid cooled equipment rack 216 to the heat exchanger 194. The purpose of the throttling valve 226 and the variable speed pump 228 will be described in greater detail below. Additionally, the second return line portion 218b includes an ejector 230 positioned after the variable speed pump 228. An ejector 230 is a type of vacuum pump, which produces vacuum by means of the Venturi effect. With an ejector 230, a working fluid flows through a jet nozzle into a tube that first narrows and then expands in cross-sectional area. A bleed valve 232 is provided to release air from the second supply line portion 214b.

It should be noted that the three-way valve 222 may be referred to herein as a first control valve and that the three-way valve 224 may be referred to herein as a second control valve. Although FIG. 6 shows the heat exchanger 194 being disposed between the refrigeration unit 174 and the first control valve, e.g., three-way valve 222, and the second control valve, e.g., three-way valve 224, it should be noted that FIG. 6 shows a schematic representation of the location of the heat exchanger, which may or may not correspond to a physical location. One side of the heat exchanger 194 is coupled to the evaporator 180 of the refrigeration unit 174 and an opposite side of the heat exchanger 194 is coupled to the three-way valves 222, 224.

One aspect of the present disclosure is that by controlling the pump 220 and the three-way valves 222, 224, a temperature of cooling fluid delivered by the first supply line portion 214a and a temperature of cooling fluid delivered by the second supply line portion 214b can be controlled. As previously described, sometimes it is desirable to provide cooling fluid to liquid cooled equipment at different or varying temperatures. In one example, the variable speed pump 220 and the three-way valve 222 can be configured to deliver a first portion of cooling fluid through the first supply line portion 214a at a first temperature, e.g., T₁. The throttling valve 226, the variable speed pump 228, and the three-way valve 224 can be configured to deliver a second portion of cooling fluid through the second supply line portion 214b at a second temperature, e.g., T₂, in which the second temperature is greater than the first temperature. Suitable temperature sensors can be provided to detect temperatures of the first portion of the cooling fluid in the first supply line portion 214a and the second portion of the cooling fluid in the second supply line portion 214b.

Another aspect of the present disclosure is that by controlling the throttling valve 226 and the pump 228, and the ejector 230, a pressure of the second portion of cooling fluid can be controlled. It may be desirable to deliver cooling fluid below atmospheric pressure. For example, in configurations where leakage is to be avoided, delivering fluid under atmospheric pressure will help to prevent any such leakage. The pressure of the second portion of the cooling fluid can be lowered by manipulating the throttling valve 226, the pump 228, and the ejector 230. The ejector 230 is further provided to more carefully regulate the pressure of the second portion of the cooling fluid and to enable the implementation of a smaller variable speed pump 228. In one example, the pump 220 can be configured to deliver a first portion of cooling fluid through the first supply line portion 214a at a first pressure, e.g., P₁. The throttling valve 226 and the pump 228 and the ejector 230 can be configured to deliver a second portion of cooling fluid through the second supply line portion 214b at a second pressure, e.g., P₂, in which the second pressure is greater than the first pressure.

Aspects of the cooling distribution units 40, 100, 170 described herein can be controlled by one or more computer systems or controllers. For example, the pumps and valves described herein can be selectively controlled by one or more controllers. In one embodiment, controller 98 is provided to control cooling distribution unit 40, controller 162 is provided to control cooling distribution unit 100, and controller 234 is provided to control cooling distribution unit 170. For example, controllers may be configured to selectively control a compressor of the refrigeration unit to achieve at least one of an economization mode, a mechanical mode, or a hybrid mode of operation. The various sensors are coupled to the controllers as well. For example, the controllers may be configured to determine the mode of operation based at least in part on an input signal from at least one temperature sensor

Various controllers may execute various operations discussed above. Using data stored in associated memory and/or storage, the controller also executes one or more instructions stored on one or more non-transitory computer-readable media, which the controller may include and/or be coupled to, that may result in manipulated data. In some examples, the controller may include one or more processors or other types of controllers. In one example, the controller is or includes at least one processor. In another example, the controller performs at least a portion of the operations discussed above using an application-specific integrated circuit tailored to perform particular operations in addition to, or in lieu of, a general-purpose processor. As illustrated by these examples, examples in accordance with the present disclosure may perform the operations described herein using many specific combinations of hardware and software and the disclosure is not limited to any particular combination of hardware and software components. Examples of the disclosure may include a computer-program product configured to execute methods, processes, and/or operations discussed above. The computer-program product may be, or include, one or more controllers and/or processors configured to execute instructions to perform methods, processes, and/or operations discussed above.

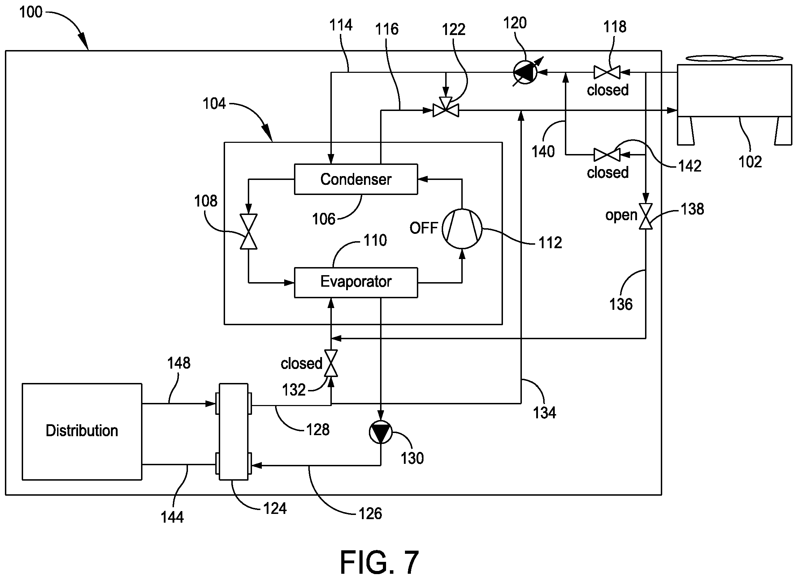

Referring to FIG. 7, with reference to aspects of the cooling distribution unit 100 shown in FIG. 5, a first operating mode, sometimes referred to as an economization or free cooling mode of operation, may be used in instances where the outside temperature is sufficiently low enough to cool the cooling fluid to a degree that is capable of cooling the warmed or hot air to a set point temperature without using the refrigeration unit. In this mode of operation, the compressor 112 of the refrigeration unit 104 is in an OFF position. Also, valve 118 is closed to cut off supply of the first cooling fluid from the dry cooling unit 102 to the condenser 106 of the refrigeration unit 104. Further, valve 132 is closed to cut off return of the third cooling fluid from the heat exchanger 124 to the evaporator 110 of the refrigeration unit 104. Further, valves 138, 142 are open and closed, respectively.

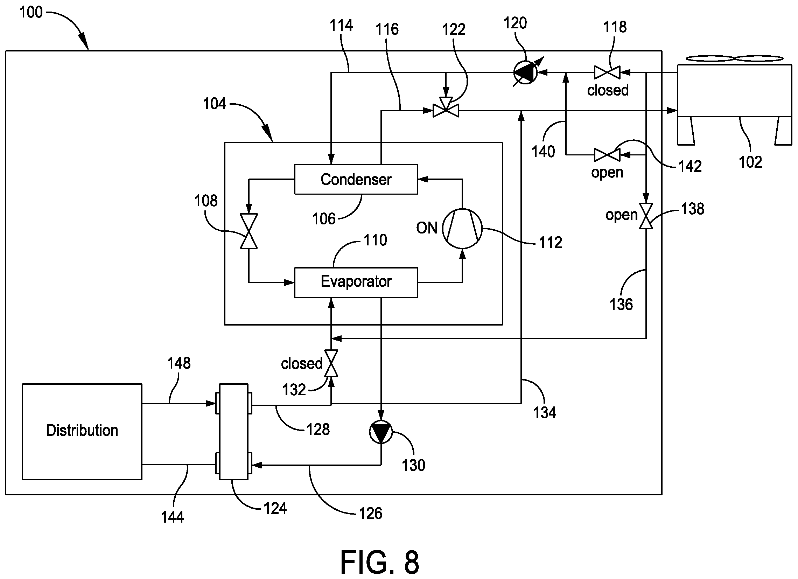

Referring to FIG. 8, also with reference to aspects of the cooling distribution unit 100 shown in FIG. 5, a second operating mode, sometimes referred to as a hybrid mode of operation, may be used in instances in which as outside temperatures cool down, the cooling fluid may be implemented for at least partial free cooling. In hybrid mode, the refrigeration unit 104 contributes to cooling. In the hybrid mode, the evaporator 110 of the refrigeration unit 104 can be operated at a lower setting than in a mechanical mode (described below), which reduces the energy consumption. In this mode of operation, the compressor 112 of the refrigeration unit is in an ON position. Also, valve 118 is closed to cut off supply of the first cooling fluid from the dry cooling unit 102 to the condenser 106 of the refrigeration unit 104. Further valve 132 is closed to cut off return of the third cooling fluid from the heat exchanger 124 to the evaporator 110 of the refrigeration unit 104. Further, valves 138, 142 are both open.

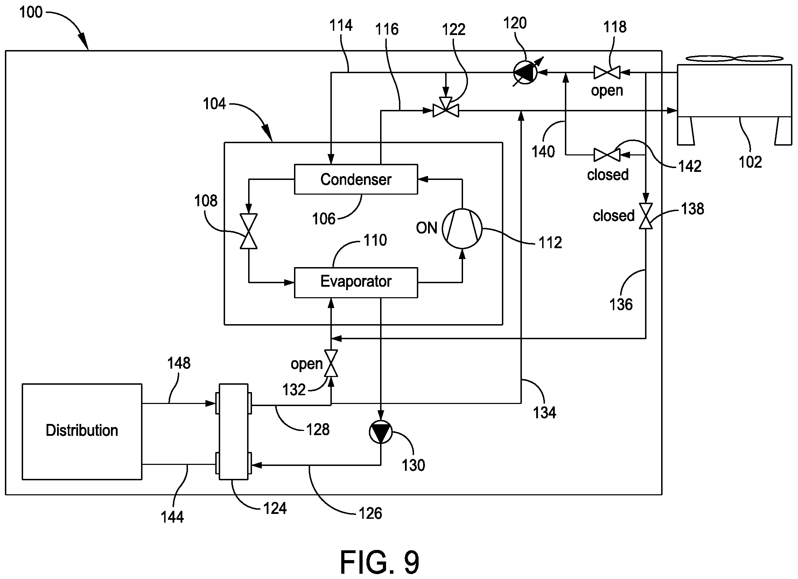

Referring to FIG. 9, also with reference to aspects of the cooling distribution unit 100 shown in FIG. 5, a third operating mode, sometimes referred to as a mechanical mode of operation, may be implemented when outdoor air is too hot or too humid to support an inlet set point, with the refrigeration unit 104 operating as a normal closed circuit system. In this mode of operation, the compressor 112 of the refrigeration unit is in an ON position. Further, valve 118 is open to provide fluid communication from the dry cooling unit 102 to the condenser 106 of the refrigeration unit via supply line 114. Further, valve 132 is open to return warmed or heated cooling fluid from the heat exchanger 124 to the evaporator 110 of the refrigeration unit 132. Further, valves 138, 142 are closed.

The aspects disclosed herein in accordance with the present disclosure, are not limited in their application to the details of construction and the arrangement of components set forth in the following description or illustrated in the accompanying drawings. These aspects are capable of assuming other embodiments and of being practiced or of being carried out in various ways. Examples of specific implementations are provided herein for illustrative purposes only and are not intended to be limiting. In particular, acts, components, elements, and features discussed in connection with any one or more embodiments are not intended to be excluded from a similar role in any other embodiments.

Also, the phraseology and terminology used herein is for the purpose of description and should not be regarded as limiting. Any references to examples, embodiments, components, elements or acts of the systems and methods herein referred to in the singular may also embrace embodiments including a plurality, and any references in plural to any embodiment, component, element or act herein may also embrace embodiments including only a singularity. References in the singular or plural form are not intended to limit the presently disclosed systems or methods, their components, acts, or elements. The use herein of "including," "comprising," "having," "containing," "involving," and variations thereof is meant to encompass the items listed thereafter and equivalents thereof as well as additional items. References to "or" may be construed as inclusive so that any terms described using "or" may indicate any of a single, more than one, and all of the described terms.

Further examples are disclosed below:
Clause 1. A cooling distribution unit, comprising:
   a refrigeration unit configured to be coupled to a dry cooling unit, the refrigeration unit being configured to receive a first cooling fluid in relatively cool condition from the dry cooling unit and to output the first cooling fluid in relatively warm condition to the dry cooling unit for cooling;
   a first control valve coupled to the refrigeration unit, the first control valve being configured to output a first portion of a second cooling fluid at a first temperature; and
   a second control valve coupled to the refrigeration unit, the second control valve being configured to output a second portion of the second cooling fluid at a second temperature.
Clause 2. The cooling distribution unit of clause 1, further comprising a pump on a return line of the second portion of the second cooling fluid, the pump being configured to control a pressure of the second portion of the second cooling fluid outputted by the second control valve.
Clause 3. The cooling distribution unit of clause 2, further comprising an ejector in fluid communication with the pump to assist in controlling the pressure of the second portion of the second cooling fluid outputted by the second control valve.
Clause 4. The cooling distribution unit of clause 1, wherein the pressure of the second portion of the second cooling fluid is less than atmospheric pressure.
Clause 5. The cooling distribution unit of clause 2, further comprising a controller configured to selectively control the first control valve, the second control valve, and the pump.
Clause 6. The cooling distribution unit of clause 5, wherein the controller further is configured to selectively control a compressor of the refrigeration unit to achieve at least one of an economization mode, a mechanical mode, or a hybrid mode of operation.
Clause 7. The cooling distribution unit of clause 6, further comprising at least one temperature sensor in communication with the controller, the controller further being configured to determine the mode of operation based at least in part on an input signal from the at least one temperature sensor.
Clause 8. The cooling distribution unit of clause 1, further comprising a heat exchanger disposed between the refrigeration unit and the first control valve and the second control valve.
Clause 9. The cooling distribution unit of clause 8, wherein the second cooling fluid is returned to the heat exchanger in a relatively warm condition, the heat exchanger being configured to cool the second cooling fluid.
Clause 10. The cooling distribution unit of clause 8, wherein the heat exchanger is coupled to the refrigeration unit, the heat exchanger being configured to receive a third cooling fluid in relatively cool condition from the refrigeration unit and to output the third cooling fluid in relatively warm condition to the refrigeration unit for cooling.
Clause 11. The cooling distribution unit of clause 1, wherein the refrigeration unit includes a condenser, a valve in fluid communication with the condenser, an evaporator in fluid communication with the valve, and a compressor in fluid communication with the evaporator and the condenser, the condenser being configured to receive the first cooling fluid in relatively cool condition from the dry cooling unit and to output the first cooling fluid in relatively warm condition to the dry cooling unit.
Clause 12. The cooling distribution unit of clause 1, further comprising at least one valve positioned between the refrigeration unit and the dry cooling unit, the at least one valve being configured to control an amount of first cooling fluid flowing to and from the dry cooling unit.
Clause 13. The cooling distribution unit of clause 1, further comprising a first pump configured to output the first portion of the second cooling fluid and a second pump configured to output the second portion of the second cooling fluid.
Clause 14. The cooling distribution unit of clause 1, further comprising a first pump on a supply line of the first portion of the second cooling fluid, and a second pump on a return line of the second portion of the second cooling fluid, the first pump being configured to control a pressure of the first portion of the second fluid and the second pump being configured to control a pressure of the second portion of the second cooling fluid.
Clause 15. The cooling distribution unit of clause 1, wherein a return line of the first portion of the second cooling fluid is coupled to a three-way valve of a supply line of the first portion of the second cooling fluid.
Clause 16. The cooling distribution unit of clause 1, wherein a return line of the second portion of the second cooling fluid is coupled to a three-way valve of a supply line of the second portion of the second cooling fluid.
Clause 17. A method of distributing cooling fluid at two different temperatures, the method comprising:
   providing a cooling fluid to a first control valve and a second control valve;
   controlling the first control valve to output a first portion of the cooling fluid at a first temperature; and
   controlling the second control valve to output a second portion of the cooling fluid at a second temperature.
Clause 18. The method of clause 17, further comprising controlling a pressure of the second portion of the cooling fluid.
Clause 19. The method of clause 18, wherein controlling the pressure includes coupling a pump to a return line of the second portion of the second cooling fluid, the pump being configured to control a pressure of the second portion of the cooling fluid outputted by the second control valve.
Clause 20. The method of clause 18, wherein controlling pressure further includes providing an ejector in fluid communication with the pump to assist in controlling the pressure of the second portion of the cooling fluid outputted by the second control valve.
Clause 21. The method of clause 18, wherein the pressure of the second cooling fluid is less than atmospheric pressure.
Clause 22. The method of clause 19, further comprising selectively controlling the first control valve, the second control valve, and the pump of the system with a controller.
Clause 23. The method of clause 22, wherein the controller further is configured to selectively control a compressor of a refrigeration unit to achieve at least one of an economization mode, a mechanical mode, or a hybrid mode of operation.
Clause 24. The method of clause 17, wherein the cooling fluid is outputted by a refrigeration unit coupled to a dry cooling unit.
Clause 25. The method of clause 24, wherein the refrigeration unit is configured to receive a first cooling fluid in relatively cool condition from the dry cooling unit and to output the first cooling fluid in relatively warm condition to the dry cooling unit for cooling.
Clause 26. The method of clause 24, wherein the first control valve and the second control valve are coupled to the refrigeration unit.
Clause 27. The method of clause 26, wherein a heat exchanger is disposed between the refrigeration unit and the first control valve and the second control valve.
Clause 28. A cooling distribution unit, comprising:
   a refrigeration unit configured to be coupled to a dry cooling unit, the refrigeration unit including a condenser, a valve in fluid communication with the condenser, an evaporator in fluid communication with the valve, and a compressor in fluid communication with the evaporator and the condenser, the condenser being configured to receive a first cooling fluid in relatively cool condition from the dry cooling unit and to output the first cooling fluid in relatively warm condition to the dry cooling unit;
   a heat exchanger coupled to the refrigeration unit, the heat exchanger being configured to receive a second cooling fluid in relatively cool condition from the evaporator of the refrigeration unit and to output the second cooling fluid in relatively warm condition to the evaporator of the refrigeration unit;
   a first control valve coupled to the heat exchanger, the first control valve being configured to output a first portion of a third cooling fluid from the heat exchanger at a first temperature;
   a second control valve coupled to the heat exchanger, the second control valve being configured to output a second portion of the third cooling fluid from the heat exchanger at a second temperature; and
   a pump coupled to a return side of the liquid cooled equipment rack, the pump being configured to control a pressure of the second portion of the third cooling fluid outputted by the second control valve.

## Claims

1. A cooling distribution unit (10, 24, 36, 40, 100, 170), comprising:
a refrigeration unit (44, 104,174) configured to be coupled to a dry cooling unit (42, 102, 172), the refrigeration unit being configured to receive a first cooling fluid in relatively cool condition from the dry cooling unit and to output the first cooling fluid in relatively warm condition to the dry cooling unit for cooling;
a first control valve (94, 152, 222) coupled to the refrigeration unit, the first control valve being configured to output a first portion of a second cooling fluid at a first temperature; and
a second control valve (96, 154, 224) coupled to the refrigeration unit, the second control valve being configured to output a second portion of the second cooling fluid at a second temperature.

2. The cooling distribution unit of claim 1, further comprising a pump (158, 228), called a second pump, on a return line (148b, 218b) of the second portion of the second cooling fluid, the second pump being configured to control a pressure of the second portion of the second cooling fluid outputted by the second control valve.

3. The cooling distribution unit of claim 2, further comprising an ejector (230) in fluid communication with the second pump to assist in controlling the pressure of the second portion of the second cooling fluid outputted by the second control valve.

4. The cooling distribution unit of claim 2 or 3, further comprising a first pump (90, 150, 220) configured to output the first portion of the second cooling fluid.

5. The cooling distribution unit of claim 4, wherein said first pump is on a supply line (84a, 144a, 214a) of the first portion of the second cooling fluid, and is configured to control a pressure of the first portion of the second cooling fluid.

6. The cooling distribution unit of any of claims 1 to 5, wherein the pressure of the second portion of the second cooling fluid is less than atmospheric pressure.

7. The cooling distribution unit of any of claims 2 to 6, further comprising a controller (98, 162, 234) configured to selectively control the first control valve, the second control valve, and at least one of said pumps.

8. The cooling distribution unit of claim 7, wherein the controller further is configured to selectively control a compressor (52, 112, 182) of the refrigeration unit to achieve at least one of an economization mode, a mechanical mode, or a hybrid mode of operation, and wherein the cooling distribution unit further preferably comprises at least one temperature sensor in communication with the controller, the controller further being configured to determine the mode of operation based at least in part on an input signal from the at least one temperature sensor.

9. The cooling distribution unit of any of above claims, further comprising a heat exchanger (64, 124, 194) disposed between the refrigeration unit and the first control valve and the second control valve,
and . wherein the second cooling fluid is preferably returned to the heat exchanger in a relatively warm condition, the heat exchanger being configured to cool the second cooling fluid.

10. The cooling distribution unit of claim 9, wherein the heat exchanger is coupled to the refrigeration unit, the heat exchanger being configured to receive a third cooling fluid in relatively cool condition from the refrigeration unit and to output the third cooling fluid in relatively warm condition to the refrigeration unit for cooling.

11. The cooling distribution unit of any of above claims, wherein the refrigeration unit includes a condenser (46, 106, 176), a valve (48, 108, 178) in fluid communication with the condenser, an evaporator (50, 110, 180) in fluid communication with the valve, and a compressor (52, 112, 182) in fluid communication with the evaporator and the condenser, the condenser being configured to receive the first cooling fluid in relatively cool condition from the dry cooling unit and to output the first cooling fluid in relatively warm condition to the dry cooling unit.

12. The cooling distribution unit of any of above claims, further comprising at least one valve (62, 122, 192, 58, 118, 188, 82, 142, 212) positioned between the refrigeration unit and the dry cooling unit, the at least one valve being configured to control an amount of first cooling fluid flowing to and from the dry cooling unit.

13. The cooling distribution unit of any of above claims, wherein a return line (88a, 148a, 218a) of the first portion of the second cooling fluid is coupled to a first three-way valve of a supply line of the first portion of the second cooling fluid, wherein the first three-way valve is preferably the first control valve, and/or wherein a return line (88b, 148b, 218b) of the second portion of the second cooling fluid is coupled to a second three-way valve of a supply line of the second portion of the second cooling fluid, wherein the second three-way valve is preferably the second control valve.

14. A method of distributing cooling fluid at two different temperatures, the method comprising:
providing a cooling fluid to a first control valve and a second control valve;
controlling the first control valve to output a first portion of the cooling fluid at a first temperature; and
controlling the second control valve to output a second portion of the cooling fluid at a second temperature.

15. The method of claim 14, further comprising operating a cooling distribution unit according to any of claims 1 to 13.
